# DEMANDE DE BREVET EUROPEEN

(11) **EP 0 626 623 A2**
(43) Date de publication de la demande: **30.11.1994**
(21) Numéro de dépôt: 94410030.4
(22) Date de dépôt: 25.04.1994
(51) Int. Cl.: G03F 9/00, G03F 7/20

(54) **Masques pour une machine d'insolation double face**

(30) Priorité: 27.04.1993 FR 9305312
(71) Demandeur: SGS-THOMSON MICROELECTRONICS S.A., F-94250 Gentilly (FR)
(72) Inventeur: Lauverjat, Eric, F-37000 Tours (FR)
(74) Mandataire: de Beaumont, Michel

(57) **Abrégé**

La présente invention concerne une paire de masques (1) destinés à l'insolation de la surface supérieure et de la surface inférieure d'une plaquette de silicium. Chaque masque comporte, en dehors de sa surface utile (5) correspondant à la surface de la plaquette de silicium des mires identiques ou complémentaires (30, 31).

## Description

La présente invention concerne la fabrication de composants semiconducteurs et plus particulièrement des machines de masquage et d'insolation double face de plaquettes semiconductrices.

Dans le domaine de la fabrication des semiconducteurs, l'une des opérations de base consiste à former sur des tranches semiconductrices des couches de masquage. Ces couches de masquage sont obtenues en déposant sur la face concernée de la plaquette une couche d'un produit photosensible, ci-après appelé résine, qui est éclairée à travers un masque choisi, cette résine étant telle que ses parties éclairées présentent ensuite des propriétés de gravure sélectives par rapport aux parties non éclairées.

Habituellement, les plaquettes semiconductrices sont soumises à des opérations de masquage sur une seule de leurs faces. Néanmoins, dans certains dispositifs, par exemple dans des composants de puissance, il est nécessaire de procéder à des opérations de masquage à la fois sur la face avant et sur la face arrière de la plaquette. Dans ce but, on a développé des machines de masquage et d'insolation qui permettent d'insoler simultanément à travers des masques choisis les faces avant et arrière d'une plaquette. Les masques considérés doivent être alignés par rapport à la plaquette à un instant donné et aussi par rapport aux masques utilisés lors d'opérations de masquage précédentes.

Dans ce but, on forme sur la plaquette et sur chaque masque des repères (ou clés) d'alignement qui permettent de positionner de façon appropriée les masques entre eux et par rapport à la plaquette avant de procéder à une opération d'insolation.

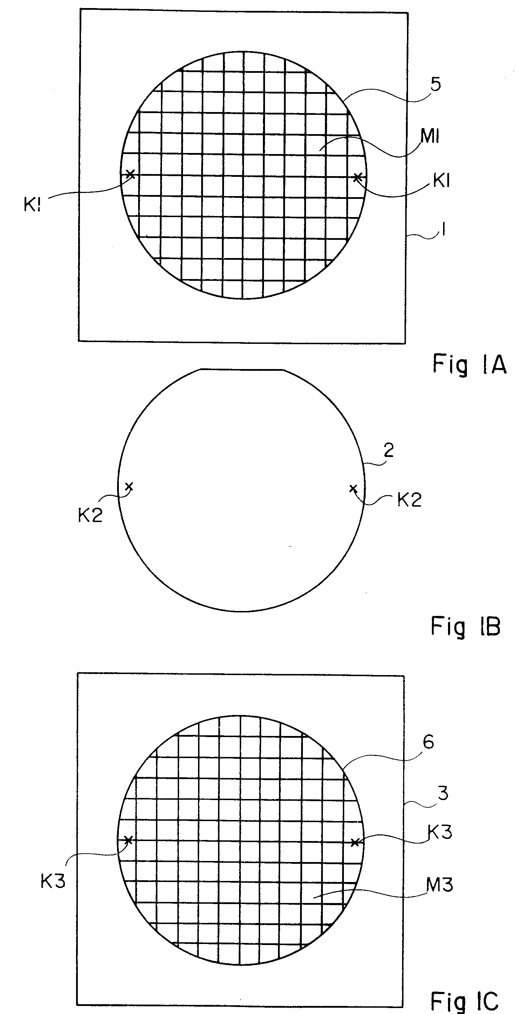

A titre d'exemple, les figures 1A, 1B et 1C représentent respectivement une vue de dessous d'un masque supérieur 1, une vue de dessous d'une plaquette de silicium 2 et une vue de dessus d'un masque inférieur 3. Chacun des masques comprend une zone utile, respectivement 5 et 6, correspondant à la surface de la plaquette 2. Chacune de ces zones utiles a été représentée munie d'un quadrillage car, habituellement, un masque comprend un très grand nombre de motifs identiques qui se répètent dans le but de former simultanément sur une plaquette des dessins de gravure identiques puisqu'ensuite la plaquette doit être divisée en un grand nombre de puces identiques. Un motif élémentaire se trouve à l'intérieur d'un carré M1 dans le masque 1 et d'un carré M3 dans le masque 3. Les masques comprennent en outre certaines zones réservées à des motifs de test ou à des motifs d'alignement. De tels motifs d'alignement sont marqués par des croix désignées par la référence K1 dans le masque 1, par la référence K2 sur la plaquette 2 et par la référence K3 sur le masque 3. Généralement, chaque masque comprend deux clés d'alignement K. Les motifs d'alignement K2 formés sur la plaquette résultent d'opérations antérieures sur cette plaquette.

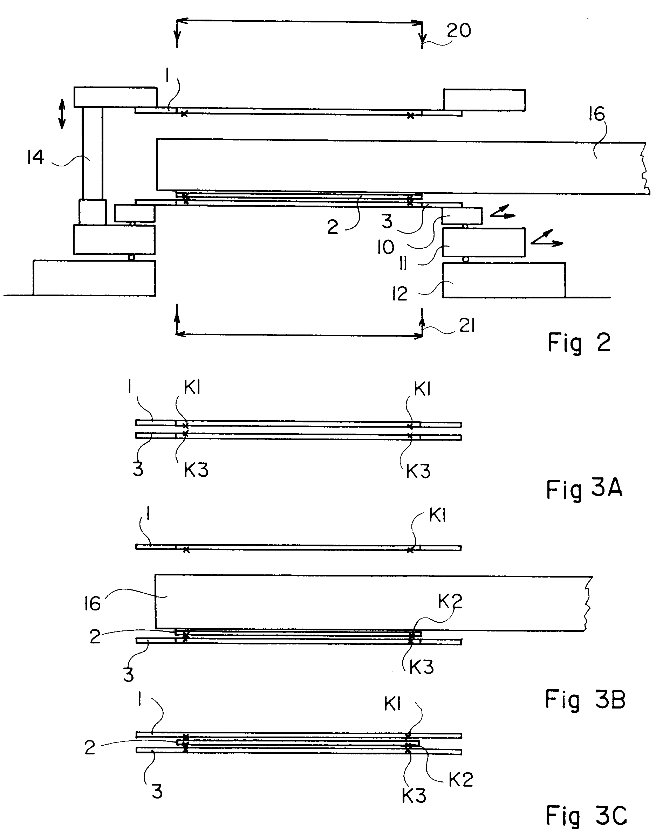

La figure 2 représente de façon très schématique une partie de la structure d'ensemble d'une machine d'insolation telle que, par exemple, fabriquée par la Société Karl Suss. Dans cette machine, le masque inférieur 3 est porté par un premier support 10 réglable en translation et en orientation (X,Y,ₘ) par rapport à un deuxième support 11 lui-même réglable en translation et en rotation par rapport au bâti 12 de la machine. Le masque supérieur 1 est fixé par un ensemble de piliers télescopiques 14, dont un seul est représenté, au deuxième support 11 de sorte que le masque 1 peut être déplacé parallèlement à lui-même et au masque 3 pour s'écarter ou se rapprocher de ce masque 3. Un bras transporteur 16 permet d'introduire la plaquette 2 entre les masques 1 et 3, de la maintenir au voisinage immédiat du masque 3, puis de la poser sur ce masque 3. Un premier système optique permet d'envoyer un faisceau de lumière parallèle d'insolation 20 sur la plaquette à travers le masque supérieur 1 et un deuxième système optique permet d'envoyer un faisceau de lumière parallèle d'insolation 21 vers la plaquette à travers le masque inférieur 3.

Le mode d'alignement des masques dans cette machine est illustré schématiquement en figures 3A, 3B et 3C.

Comme le représente la figure 3A, dans une première étape, avant introduction de la plaquette de silicium 2, les piliers télescopiques 14 sont actionnés pour que le masque 1 se trouve par rapport au masque 3, sensiblement à la position qu'il occupera une fois la plaquette mise en place et immédiatement avant l'étape d'insolation. Alors, en suivant un trajet optique, qui correspond par exemple à celui du faisceau d'éclairement 21, on examine au microscope l'alignement des repères K1 et K3 et l'on agit sur la position du support 10 par rapport au support 11 pour réaliser l'alignement souhaité entre les masques.

Dans une deuxième étape illustrée en figure 3B, on remonte le masque 1 en agissant sur les piliers télescopiques 14 et on introduit la plaquette 2 au-dessus et au voisinage immédiat du masque 3 à l'aide du bras transporteur 16. Puis, à l'aide du microscope précédemment utilisé, on aligne les repères K3 du masque inférieur par rapport aux repères K2 de la plaquette en agissant sur le réglage en X, Y et ₘ du support 11 par rapport à l'embase 12. On notera que lors de ce réglage, on déplace simultanément et de la même quantité les masques 1 et 3 qui sont rendus solidaires par les piliers 14. Après cela, on pose la plaquette 2 sur le masque 3, on retire le bras convoyeur 16 et on rapproche le masque supérieur de la plaquette. L'alignement est ainsi achevé et la plaquette est prête à être insolée sur ses deux faoes.

On notera qu'une fois le système remis dans la configuration prête à l'insolation de la figure 3C, il n'est pas possible de vérifier à nouveau l'alignement entre les repères K1 et K3 puisque la plaquette 2 occulte le trajet optique entre ces repères.

Or, en pratique, les utilisateurs s'aperçoivent que les machines du type décrit fonctionnent généralement de façon satisfaisante mais que l'on rencontre parfois des séries d'insolations qui présentent un défaut d'alignement entre les deux faces de la plaquette de silicium. Ce défaut d'alignement est attribué par la demanderesse à un décalage du masque 1 lors de l'opération de montée et descente de ce masque.

Un objet de la présente invention est de prévoir un moyen simple de détection d'un tel défaut.

Pour atteindre cet objet, la présente invention prévoit une paire de masques destinés à l'insolation de la surface supérieure et de la surface inférieure d'une plaquette de silicium. Chaque masque comporte, en dehors de sa surface utile correspondant à la surface de la plaquette de silicium des mires identiques ou complémentaires.

Les mires sont par exemple constituées de damiers ou d'anneaux concentriques opaques et transparents.

La présente invention prévoit aussi une machine d'insolation double face d'une plaquette de silicium revêtue de résine photosensible à travers un premier et un deuxième masque disposés de part et d'autre de la plaquette, comprenant : des repères d'alignement en regard sur la plaquette et sur chacun des masques ; des moyens d'écartement des premier et deuxième masques ; des moyens d'introduction de la plaquette entre les deux masques ; des moyens de réglage en translation/rotation du premier masque par rapport au deuxième masque ; des moyens de réglage en translation/rotation de l'ensemble des deux masques par rapport à la plaquette. Les deux masques comprennent en outre en dehors de leurs zones correspondant à la surface de la plaquette des motifs identiques ou complémentaires de transparence et d'opacité et la machine comprend au moins une source lumineuse et un photorécepteur disposés de sorte que le chemin optique entre eux traverse un motif de chacun des masques, d'où il résulte que le photodétecteur détecte une intensité lumineuse extrême quand les masques sont alignés.

Selon un mode de réalisation de la présente invention, les deux masques sont complémentaires et en forme de damiers.

Selon un mode de réalisation de la présente invention, les deux masques sont identiques et en forme d'anneaux concentriques.

Ces objets, caractéristiques et avantages ainsi que d'autres de la présente invention seront exposés en détail dans la description suivante de modes de réalisation particuliers faite en relation avec les figures jointes parmi lesquelles :
les figures 1A, 1B et 1C représentent respectivement un masque supérieur, une plaquette de silicium et un masque inférieur ;
la figure 2 représente le système d'alignement de masques d'une machine d'insolation classique ;
les figures 3A, 3B, 3C illustrent des étapes successives d'alignement de masques dans la machine de la figure 2 ;
la figure 4 représente un masque modifié selon un mode de réalisation de la présente invention ; et
la figure 5 représente un système de détection de désalignement de masques selon la présente invention.

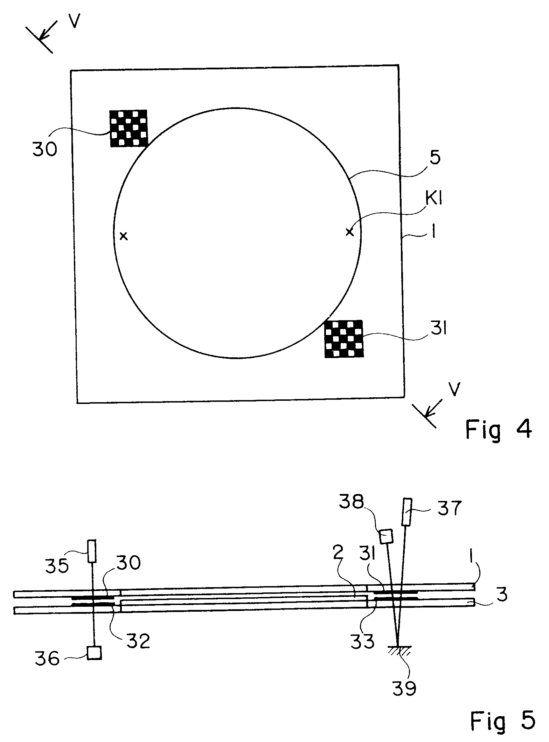

Le masque supérieur 1 modifié selon un mode de réalisation de la présente invention illustré en figure 4 comprend, en dehors de la zone utile 5, des motifs ou mires de zones opaques et transparentes 30, 31, disposées par exemple diagonalement de la façon représentée. Le masque inférieur comprend aux mêmes emplacements des mires complémentaires. Ainsi, quand les deux masques sont alignées par un alignement de leurs repères K1, K3, la superposition des mires supérieures et inférieures forme un écran opaque. Toutefois, dès que l'un des masques est désaligné par rapport à l'autre, de la lumière peut traverser deux mires superposées.

Ainsi, la présente invention propose d'utiliser, dans une machine du type de celle de la figure 2, des masques du type de celui de la figure 4 et d'adjoindre à la machine d'insolation des moyens optiques de détection de l'alignement ou du désalignement des mires des masques supérieur et inférieur.

La figure 5 représente en vue en coupe l'ensemble d'un masque supérieur 1, d'une plaquette 2 et d'un masque inférieur 3 en position pour être insolés. Le masque supérieur comporte des mires 30, 31 et le masque inférieur des mires complémentaires 32, 33 (la figure 5 est une vue en coupe prise selon la diagonale V-V de la figure 4). On adjoint à la machine de la figure 2 un dispositif de détection optique de l'alignement des mires 30-32 et 31-33. Ce dispositif de détection d'alignement peut, comme cela est représenté dans la partie gauche de la figure 5, être constitué d'un photo-émetteur 35 tel qu'une diode laser en face duquel est disposé un photorécepteur 36 tel qu'une photodiode. On peut aussi disposer, comme cela est représenté dans la partie droite de la figure 5, un photo-émetteur 37 et un photorécepteur 38 du même côté de l'ensemble à insoler, par exemple au-dessus du masque supérieur 1, la lumière étant renvoyée par un miroir 39 si les mires 31 et 33 sont décalées.

Comme cela est représenté en figure 4, les mires 30 peuvent être simplement constituées de damiers ayant par exemple une dimension de case de l'ordre de 1 à 5 ^{e}m, ce qui est suffisant pour détecter un décalage supérieur à 0,5 ^{e}m. Si, grâce au système de vérification selon la présente invention, on détecte un défaut d'alignement entre les masques supérieur et inférieur, toutes les étapes d'alignement de masques décrites en relation avec la figure 2 et les figures 3A à 3C seront reprises, le dispositif selon l'invention étant de préférence seulement utilisé comme dispositif de détection de défaut et non comme moyen de réalignement des masques.

Le système selon la présente invention est simplement adaptable à des machines d'insolation double face existantes dans lesquelles les systèmes de préhension des masques, couramment des systèmes à aspiration, empiètent sur la périphérie de ces masques mais laissent toujours en pratique une zone dégagée entre la limite utile du masque (correspondant à la surface de plaquette de silicium) et sa périphérie. En outre, il existe des diodes laser et des diodes photosensibles miniaturisées qui peuvent facilement être disposées dans des espaces disponibles de la machine. De préférence, la vérification selon la présente invention sera réalisée de façon automatique par un automate gérant la machine d'insolation et effectuant la vérification d'alignement des masques après la fin des étapes classiques d'alignement en activant brièvement les diodes laser et en détectant la lumière reçue. Bien entendu, il sera fixé un seuil de lumière pour détecter un réglage minimal. D'autre part, les surfaces des zones opaques en damiers peuvent être légèrement supérieures aux surfaces des zones claires pour ne faire la détection qu'au delà d'un niveau de déréglage déterminé et pour tenir compte des effets de bord.

Par ailleurs, dans la description précédente d'un mode de réalisation de la présente invention, on a proposé des mires en damiers complémentaires. Toute autre forme de mires complémentaires pourra être utilisée. D'autre part, au lieu d'utiliser des mires complémentaires, on pourra utiliser des mires identiques. Alors, au lieu de détecter un minimum de lumière, on détectera un maximum. Ces mires identiques peuvent par exemple prendre la forme d'anneaux concentriques alternativement opaques et transparents.

## Revendications

1. Paire de masques (1, 3) destinés à l'insolation de la surface supérieure et de la surface inférieure d'une plaquette de silicium (2), caractérisée en ce que chaque masque comporte, en dehors de sa surface utile (5, 6) correspondant à la surface de la plaquette de silicium des mires identiques ou complémentaires (30, 32 ; 31, 33).

2. Paire de masques selon la revendication 1, caractérisée en ce que lesdites mires sont constituées de damiers opaques et transparents.

3. Paire de masques selon la revendication 1, caractérisée en ce que lesdites mires sont constituées d'anneaux concentriques opaques et transparents.

4. Machine d'insolation double face d'une plaquette de silicium revêtue de résine photosensible à travers un premier et un deuxième masque disposés de part et d'autre de la plaquette, comprenant :
des repères d'alignement (K2, K1, K3) en regard sur la plaquette (2) et sur chacun des masques (1, 3) ;
des moyens (14) d'écartement des premier et deuxième masques ;
des moyens (16) d'introduction de la plaquette entre les deux masques ;
des moyens de réglage en translation/rotation du premier masque par rapport au deuxième masque ;
des moyens de réglage en translation/rotation de l'ensemble des deux masques par rapport à la plaquette ;
caractérisée en ce que les deux masques comprennent en outre en dehors de leurs zones correspondant à la surface de la plaquette des motifs identiques ou complémentaires (30, 31) de transparence et d'opacité et en ce que la machine comprend au moins une source lumineuse (35 ; 37) et un photorécepteur (36 ; 38) disposés de sorte que le chemin optique entre eux traverse un motif de chacun des masques, d'où il résulte que le photodétecteur détecte une intensité lumineuse extrême quand les masques sont alignés.

5. Machine d'insolation selon la revendication 4, caractérisée en ce que la source lumineuse est une diode laser.

6. Machine d'insolation selon la revendication 4, caractérisée en ce que le photorécepteur est une diode photosensible.

7. Machine d'insolation selon la revendication 4, caractérisée en ce que les motifs sur les deux masques sont complémentaires et en forme de damiers.

8. Machine d'insolation selon la revendication 4, caractérisée en ce que les motifs sur les deux masques sont identiques et en forme d'anneaux concentriques.
